# EUROPÄISCHE PATENTSCHRIFT

(11) **EP 1 163 680 B1**
(45) Veröffentlichungstag und Bekanntmachung des Hinweises auf die Patenterteilung: **11.12.2002**
(21) Anmeldenummer: 00920381.1
(22) Anmeldetag: 13.03.2000
(51) Int. Cl.: G11C 29/00

(54) **VORRICHTUNG UND VERFAHREN FÜR DEN EINGEBAUTEN SELBSTTEST EINER ELEKTRONISCHEN SCHALTUNG**
DEVICE AND METHOD FOR CARRYING OUT THE BUILT-IN SELF-TEST OF AN ELECTRONIC CIRCUIT
PROCEDE ET DISPOSITIF POUR AUTO-CONTROLE INTEGRE D'UN CIRCUIT ELECTRONIQUE

(30) Priorität: 17.03.1999 DE 19911939
(43) Veröffentlichungstag der Anmeldung: 19.12.2001
(73) Patentinhaber: Infineon Technologies AG, 81669 München (DE)
(72) Erfinder: KNIFFLER, Oliver, D-81737 München (DE); DIRSCHERL, Gerd, D-81543 München (DE)
(74) Vertreter: Epping Hermann & Fischer
(86) Internationale Anmeldenummer: DE0000775
(87) Internationale Veröffentlichungsnummer: WO00055863

(56) Entgegenhaltungen:
- EP-A- 0 340 895
- US-A- 5 689 466

## Beschreibung

Die vorliegende Erfindung betrifft ein Verfahren für den eingebauten Selbsttest einer elektronischen Schaltung, die sowohl kombinatorische Logik als auch Speicher enthält.

Bisher war der Hardwareaufwand für die Testlogik eines eingebauten Selbsttests (Built-In Selftest = BIST) bei solchen elektronischen Schaltungen, die sowohl kombinatorische Logik als auch Speicherelemente (RAM und/oder ROM) enthalten, außerordentlich groß, da die kombinatorische Logik und die in der gleichen Schaltung enthaltenen Speicher gemäß dem Stand der Technik stets voneinander getrennt getestet wurden. Gemäß dem Stand der Technik gab es also sowohl eine Selbsttestschaltung für den Test der Logik als auch eine separate Selbsttestschaltung, die nur den Speicheranteil testet. Damit ist natürlich ein erheblich höherer Schaltungsaufwand und meist.auch eine höhere Testzeit verbunden.

Ein Verfahren gemäß dem Oberbegriff des Anspruchs 1 ist aus der EP-0 340 895 A bekannt.

Es ist daher Aufgabe der Erfindung, ein Verfahren für den eingebauten Selbsttest einer elektronischen Schaltung anzugeben, die sowohl kombinatorische Logik als auch Speicher enthält, wobei diese Vorrichtung und dieses Verfahren mit erheblich geringerem Hardwareaufwand realisierbar sein soll und vorzugsweise auch der Zeitaufwand für den Selbsttest verringert werden soll.

Die vorliegende Erfindung löst diese Aufgabe durch ein Verfahren nach dem Patentanspruch 1.

Dabei ist es besonders bevorzugt, den Selbsttest mittels eines Taktes zu steuern, der sowohl einen Zähler zur Adressierung des Speichers als auch einen Pseudozufallsmustergenerator taktet, der die Eingabedaten sowohl für die kombinatorische Logik als auch für den Speicher liefert.

Es ist dabei besonders bevorzugt, die Ausgangsdaten der kombinatorischen Logik und des Speichers einem Signaturregister zuzuführen, in dem diese Daten komprimiert werden. Auf diese Weise genügt für den gesamten Selbsttest ein einziges Signaturregister.

Ein besonders übersichtlicher Ablauf des Selbsttests ergibt sich, wenn der Zähler die Adresse des Speichers bestimmt, an die die Daten des Pseudozufallsgenerators geschrieben werden.

Besonders bevorzugt ist es dabei, wenn das höchstwertige Bit des Zählers bestimmt, ob auf den Speicher geschrieben oder aus dem Speicher gelesen wird, so daß beim Durchzählen des Zählers zuerst alle Speicheradressen geschrieben und sodann ausgelesen werden. Wenn also der Zähler hochzählt, muß der Zustand Schreiben dem höchstwertigen Bit bei 0 und der Zustand Lesen dem höchstwertigen Bit bei 1 entsprechen. Wenn der Zähler abwärts (also rückwärts) zählt, muß das höchstwertige Bit 1 Schreiben und das höchstwertige Bit 0 Lesen bedeuten.

Weiter ist es besonders bevorzugt, daß das Ende des Selbsttests durch den Überlauf des Zählers bestimmt wird.

Als Signaturregister und als Pseudozufallsgenerator werden vorzugsweise jeweils rückgekoppelte Schieberegister verwendet.

Die vorliegende Erfindung wird im folgenden anhand des in den beiliegenden Zeichnungen dargestellten Ausführungsbeispiels näher erläutert. Es zeigen:
**Fig. 1** ein Übersichts-Blockschaltbild über eine erfindungsgemäße Selbsttestschaltung;
**Fig. 2** eine detailliertere Detaildarstellung der erfindungsgemäßen Selbsttestschaltung der Fig. 1.

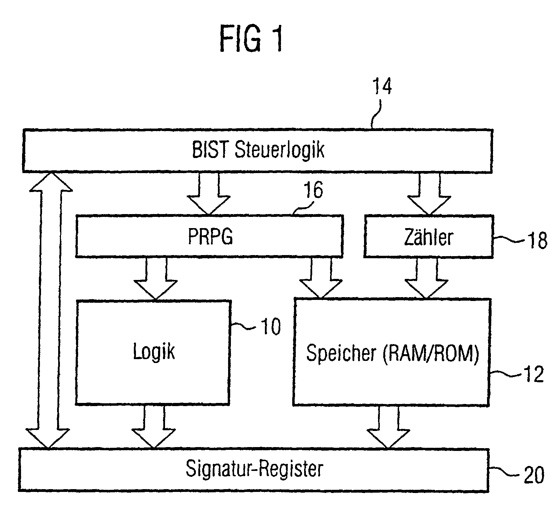

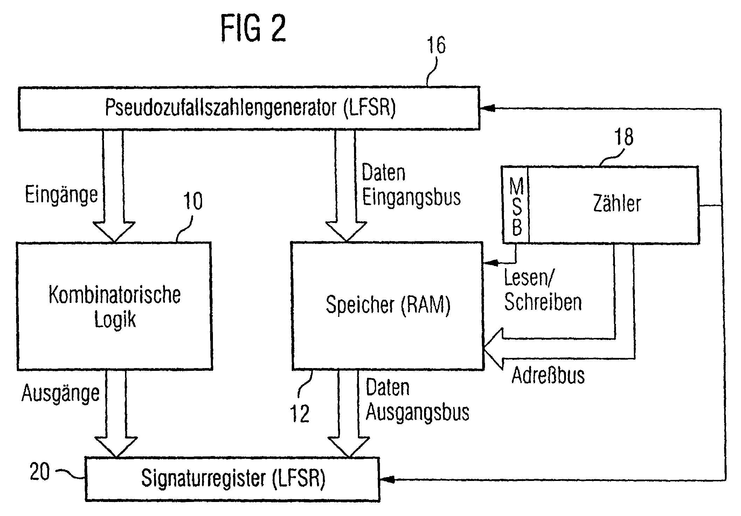

Wie in Fig. 1 dargestellt, dient die vorliegende Erfindung als Testschaltung für den eingebauten Selbsttest (Built-In Selftest = BIST) einer elektronischen Schaltung, die sowohl kombinatorische Logik 10 als auch Speicher (RAM und/oder ROM) 12 enthält. Der gesamte Ablauf des eingebauten Selbsttests wird von der BIST-Steuerlogik 14 gesteuert (in Fig. 2 nicht dargestellt). Dazu verfügt die Steuerlogik 14 über Zugriffsmöglichkeiten auf die Daten der weiteren, zur Durchführung des Selbsttests dienenden Schaltungskomponenten. Diese sind ein Pseudozufallsmustergenerator (PRPG) 16, ein Zähler 18 und ein Signaturregister 20.

Wie in Fig. 2 im einzelnen dargestellt, sind die Ausgänge des Pseudozufallszahlengenerators 16 mit den Eingängen der kombinatorischen Logik 10 und den Dateneingängen des Speichers 12 verbunden. Die Ausgänge der kombinatorischen Logik 10 und der Datenausgang des Speichers 12 sind mit dem Signaturregister 20 verbunden. Der Zähler 18 ist mit seinem höchstwertigen Bit (MSB) mit dem Lese/Schreib-Steuereingang des Speichers 12 verbunden, während alle anderen Bits des Zählers 18 mit den Adresseingängen des Speichers 12 verbunden sind.

Der Ablauf eines solchen Selbsttests, beispielsweise bei einer Schaltung, die als Instruction Cache einer CPU (Zentralprozessoreinheit) dient, ist folgendermaßen:

Der Ablauf des Selbsttests wird durch die Steuerlogik 14 kontrolliert. Beim Start wird das zu testende Modul, welches aus Logik 10 und Speicher 12 besteht, sowie der Zähler 18 für die Adressierung des Speichers 12, der Pseudozufallsmustergenerator (PRPG) 16 und das Signaturregister 20 zurückgesetzt. Während des Tests wird der Zähler getaktet und zählt dadurch durch. Der Zählerstand wird dabei dazu benutzt, alle Speicherstellen des Speichers 12 zu selektieren und im Falle eines Schreib- Lesespeichers (RAM) auch zwischen Schreiben und Lesen zu wechseln. Dazu wird beispielsweise das höchstwertige Bit (MSB) oder das niederwertigste Bit des Zählers 18 verwendet. Parallel dazu wird die kombinatorische Logik 10 wie auch im Stand der Technik üblich mit den Pseudozufallsmustern aus dem Pseudozufallszahlengenerator 16 stimuliert. Erfindungsgemäß werden jedoch gleichzeitig die gleichen Ausgangsdaten des Pseudozufallszahlengenerators 16 zum Beschreiben des Speichers 12 benutzt.

Die Ausgänge der kombinatorischen Logik 10 und des Speichers 12 führen zu dem Signaturregister 20, in dem die entsprechenden Ausgangsdaten komprimiert und gespeichert werden. Nach Ablauf des Selbsttests, dessen Dauer durch die Steuerlogik oder durch den Zähler 18 gesteuert wird, beispielsweise durch Erkennung des Überlaufs des Zählers 18 oder durch Erkennung eines bestimmten Zählerstandes durch einen Komparator wird der Inhalt des Signaturregisters mit einem Referenzwert verglichen.

Als Pseudozufallszahlengenerator und als Signaturregister werden vorzugsweise rückgekoppelte Schieberegister, beispielsweise linear oder nichtlinear rückgekoppelte Schieberegister oder zelluläre Automaten, verwendet. Als Speicher können beliebige Speicher getestet werden, wenn es sich bei den Speichern um Nur-Lesespeicher (ROM) handelt, dient der Stand des Zählers 18 zur sukzessiven Adressierung für einen Lesezugriff.

Hierbei wird vorzugsweise folgende Vorgehensweise gewählt:

Beim Starten des Selbsttests erfolgt wieder ein Zurücksetzen aller Komponenten. Der übrige Testablauf wird im wesentlichen vom Zähler 18 gesteuert. Beim Starten des Zählers wird das Signaturregister 20 zurückgesetzt und der Pseudozufallszahlengenerator 16 von der Steuerlogik 14 mit einem Startwert geladen. Jedesmal, wenn der Zähler weiterzählt, erzeugt der Zufallszahlengenerator 16 ein Testmuster, das die Eingänge der kombinatorischen Logik 10 speist. Gleichzeitig wird das Muster in den Speicher 12 geschrieben. Der Zählerstand bestimmt dabei die Adresse im Speicher 12. Mit dem höchstwertigen Bit (MSB), des Zählers 18 wird zwischen Schreiben und Lesen unterschieden (zuerst muß der Speicher mit den Mustern beschrieben werden, dann muß der gesamte Speicher ausgelesen werden).

Hierbei kann der Zähler entweder vom Zählerstand 0 hochgezählt werden, dann entspricht das höchstwertige Bit 0 dem Zustand Schreiben und das höchstwertige Bit 1 dem Zustand Lesen. Umgekehrt kann der Zähler natürlich auch von dem Zählerstand 1111... aus heruntergezählt werden. Dann muß lediglich die Zuordnung des höchstwertigen Bits zu Lesen und Schreiben vertauscht werden. Gleichzeitig werden die Ausgänge der kombinatorischen Logik 10 sowie der Datenausgangsbus (beim Lesen) des Speichers 12 in das Signaturregister 20 übertragen und dort komprimiert.

Wenn der Zähler 18 abgelaufen ist (beispielsweise bei Zählerüberlauf oder beim Rückwärtszählen bei Zähler 0) oder beim Erreichen eines vorher festgelegten Zählerstandes wird der Selbsttest beendet. Der Inhalt des Signaturregisters kann danach ausgelesen und mit einem Referenzwert, der beispielsweise durch Simulation bestimmt werden kann, verglichen werden.

Erfindungsgemäß werden also kombinatorische Logik und die darin eingebetteten Speicher nicht mehr getrennt voneinander getestet, also durch verschiedene Testhardware und womöglich auch noch zeitlich hintereinander, sondern gleichzeitig und weitgehend unter Verwendung der gleichen Testhardware. Dadurch kann erheblicher doppelter Schaltungsaufwand (z.B. Signaturregister, Testzeitzähler, Steuerlogik) vermieden werden, und der Selbsttest beider Komponenten findet zwingend gleichzeitig statt. Dadurch ergibt sich darüber hinaus eine erhebliche Testzeitersparnis.

## Patentansprüche

1. Verfahren für den eingebauten Selbsttest einer elektronischen Schaltung, die sowohl kombinatorische Logik (10) als auch Speicher (12) enthält, wobei eine gemeinsame Selbsttestschaltung für die Logik (10) und den Speicher (12) vorgesehen ist, die einen Pseudozufallsmustergenerator (16) und ein sowohl mit der Logik (10) als auch mit dem Speicher (12) verbundes Signaturregister (20) aufweist, wobei mittels eines Zählers (18) der Speicher (12) adressiert wird
**dadurch gekennzeichnet, daß**
zum gleichzeitigen Testen von Logik und Speicher die Logik (10) mit Mustern aus dem Pseudozufallsmustergenerator (16) stimuliert wird und gleichzeitig die gleichen Muster des Pseudozufallsmustergenerators (16) zum Beschreiben des Speichers (12) benutzt werden.

2. Verfahren nach Anspruch 1,
**dadurch gekennzeichnet, daß**
der Selbsttest mittels eines Taktes gesteuert wird, der sowohl den Zähler (18) zur Adressierung des Speichers (12) als auch den Pseudozufallszahlengenerator (16) taktet, der die Eingabedaten sowohl für die kombinatorische Logik (10) als auch für den Speicher (12) liefert.

3. Verfahren nach Anspruch 1 oder 2,
**dadurch gekennzeichnet, daß**
die Ausgangsdaten der kombinatorischen Logik (10) und des Speichers (12) einem Signaturregister (20) zugeführt werden, in den diese Daten komprimiert werden.

4. Verfahren nach einem der Ansprüche 1 bis 3,
**dadurch gekennzeichnet, daß**
der Zähler (18) die Adresse des Speichers (12) bestimmt, an die die Daten des Pseudozufallsgenerators (16) geschrieben werden.

5. Verfahren nach Anspruch 4,
**dadurch gekennzeichnet, daß**
das höchstwertige Bit des Zählers (18) bestimmt, ob auf den Speicher (12) geschrieben oder aus dem Speicher (12) gelesen wird, so daß beim Durchzählen des Zählers (18) zuerst alle Speicheradressen beschrieben und sodann ausgelesen werden.

6. Verfahren nach Anspruch 4 oder 5,
**dadurch gekennzeichnet, daß**
das Ende des Selbsttests durch den Überlauf des Zählers (18) bestimmt wird.

7. Verfahren nach einem der Ansprüche 1 bis 6,
**dadurch gekennzeichnet, daß**
als Signaturregister (20) und als Pseudozufallsgenerator (16) jeweils rückgekoppelte Schieberegister verwendet werden.

## Claims

1. Method for the built-in selftest of an electronic circuit which contains both a combinatorial logic (10) and a memory (12), a common selftest circuit being provided for the logic (10) and the memory (12), which selftest circuit has a pseudo-random pattern generator (16) and a signature register (20) which is connected both to the logic (10) and to the memory (12), the memory (12) being addressed by means of a counter (18), **characterized in that** the logic (10) is stimulated with patterns from the pseudo-random pattern generator (16) to simultaneously test the logic and the memory, and at the same time the same patterns of the pseudo-random pattern generator (16) are used for writing to the memory (12).

2. Method according to Claim 1, **characterized in that** the selftest is controlled by means of a clock pulse which clocks both the counter (18) for addressing the memory (12) and the pseudo-random number generator (16) which supplies the input data both for the combinatorial logic (10) and for the memory (12).

3. Method according to Claim 1 or 2, **characterized in that** the output data of the combinatorial logic (10) and of the memory (12) are fed to a signature register (20) in which this data is compressed.

4. Method according to one of Claims 1 to 3, **characterized in that** the counter (18) determines the address of the memory (12) to which the data of the pseudo-random generator (16) is written.

5. Method according to Claim 4, **characterized in that** the most significant bit of the counter (18) determines whether the memory (12) is written to or the memory (12) is read so that, as the counter (18) increments or decrements, all the memory addresses are first written to and then read.

6. Method according to Claim 4 or 5, **characterized in that** the end of the selftest is determined by the counter (18) overflowing.

7. Method according to one of Claims 1 to 6, **characterized in that** fed-back shift registers are used respectively as the signature register (20) and as the pseudo-random generator (16).

## Revendications

1. Procédé de test intégré automatique d'un circuit électronique qui a aussi bien de la logique combinatoire (10) que de la mémoire (12), dans lequel il est prévu un circuit de test automatique commun pour la logique (10) et la mémoire (12) qui comporte un générateur de trames pseudo-aléatoires (16) et un registre de signatures (20) relié aussi bien à la logique (10) qu'à la mémoire (12), et dans lequel la mémoire (12) est adressée au moyen d'un compteur (18),
**caractérisé en ce que**, pour effectuer simultanément le test de la logique et de la mémoire, la logique (10) est excitée avec des trames générées par le générateur de trames pseudo-aléatoires (16) et en même temps les mêmes trames du générateur de trames pseudo-aléatoires (16) sont utilisées pour écrire dans la mémoire (12).

2. Procédé selon la revendication 1, **caractérisé en ce que** le test automatique est commandé au moyen d'un signal d'horloge qui attaque aussi bien le compteur (18) pour l'adressage de la mémoire (12) que le générateur de nombres pseudo-aléatoires (16) qui délivre les données d'entrée aussi pour la logique combinatoire (10) que pour la mémoire (12).

3. Procédé selon la revendication 1 ou 2, **caractérisé en ce que** les données de sortie de la logique combinatoire (10) et de la mémoire (12) sont amenées à un registre de signatures (20) dans lequel ces données sont entrées à l'état comprimé.

4. Procédé selon l'une des revendications 1 à 3, **caractérisé en ce que** le compteur (18) détermine l'adresse de la mémoire (12) à laquelle sont écrites les données du générateur pseudo-aléatoire (16).

5. Procédé selon la revendication 4, **caractérisé en ce que** le binaire de poids le plus grand du compteur (18) détermine s'il faut écrire dans la mémoire (12) ou lire dans la mémoire (12) de sorte que, lorsque le compteur défile, l'on écrit tout d'abord à toutes les adresses de la mémoire puis on lit celles-ci.

6. Procédé selon la revendication 4 ou 5, **caractérisé en ce que** la fin du test automatique est déterminé par le dépassement de capacité du compteur (18).

7. Procédé selon l'une des revendications 1 à 6, **caractérisé en ce qu'**il est utilisé des registres à décalage à rétroaction comme registre de signatures (20) et comme générateur pseudo-aléatoire (16).
